## Europäisches Patentamt
## European Patent Office
## Office européen des brevets

(19)

(11) Numéro de publication: **0 207 922 B1**

(12) **FASCICULE DE BREVET EUROPEEN**

(45) Date de publication du fascicule du brevet: **03.10.90**

(51) Int. Cl.⁵: **G 01 R 19/15,** G 01 R 31/02, H 05 B 37/03

(21) Numéro de dépôt: **86870077.4**

(22) Date de dépôt: **29.05.86**

(54) **Procédé et dispositif de surveillance de balises lumineuses.**

(30) Priorité: **20.06.85 BE 215229**

(43) Date de publication de la demande:
**07.01.87 Bulletin 87/02**

(45) Mention de la délivrance du brevet:
**03.10.90 Bulletin 90/40**

(84) Etats contractants désignés:
**AT CH DE FR GB IT LI LU NL SE**

(56) Documents cités:
**DE-A-3 012 726**
**DE-A-3 144 018**
**FR-A-2 274 981**
**GB-A-2 029 616**
**US-A-3 054 991**

(73) Titulaire: **Siemens Aktiengesellschaft**
**Wittelsbacherplatz 2**
**D-8000 München 2 (DE)**

(72) Inventeur: **Delflache, Robert**
**Rue des Pommiers 35**
**B-7490 Braine-le-Comte (BE)**

Courier Press, Leamington Spa, England.

## Description

La présente invention concerne la surveillance de balises lumineuses d'aérodromes et plus particulièrement un dispositif de surveillance pour détecter de façon continue le nombre de balises défectueuses dans une installation.

Les balises lumineuses d'aérodromes sont des lampes installées notamment le long des pistes, voies de circulation et approches des aérodromes afin de servir d'aide visuelle à la navigation pour les pilotes d'avion. Ces balises sont généralement connectées à des transformateurs d'isolement ayant leurs circuits primaires qui sont reliés en série par une boucle alimentée par un régulateur à courant constant, chaque lampe étant connectée au circuit secondaire d'un transformateur d'isolement. Dans ces installations, le nombre de balises défectueuses ne peut jamais excéder un nombre de quelques unités imposé par les réglementations de sécurité. Aussi est-il impératif que les balises soient surveillées en permanence et que le nombre de balises qui viennent à être défectueuses soit détecté.

Lorsqu'une balise devient défectueuse, elle ouvre le circuit secondaire du transformateur d'isolement auquel elle est connectée et ce transformateur est alors le siège d'une pointe de tension étroite pendant que l'induction instantanée du transformateur change de signe. Cette points de tension se superpose à la somme des tensions sur tous les transformateurs d'isolement dont les secondaires sont restés fermés, c'est-à-dire les transformateurs associées aux balises restées opérationnelles.

On peut montrer que l'intégrale d'une telle pointe de tension dépend très peu de la forme d'onde et de l'amplitude du courant dans la boucle pourvu que ce courant soit beaucoup plus grand que le courant de saturation des transformateurs, ce qui est toujours le cas en pratique dans les installations d'aérodromes. Lorsque plusieurs balises se trouvent défectueuses, plusieurs pointes de tension se superposent ainsi et l'intégrale de ces points de tension est une image du nombre de transformateurs dont le circuit secondaire est ouvert, c'est-à-dire une image du nombre de balises défectueuses. Il est donc possible de déterminer ce nombre en mesurant l'intégrale des pointes de tension superposées. Pour obtenir une bonne précision de détection, il y a intérêt à déterminer l'intégrale sur un intervalle de temps durant lequel les pointes de tension superposées ont une valeur significative.

Un dispositif pour engendrer une tension indiquant le nombre de transformateurs d'isolement ayant leur circuit secondaire ouvert est connu par le brevet US—A—4 323 841. Dans ce dispositif connu, la tension de sortie est l'intégrale de la tension de la boucle depuis l'instant où le courant de boucle dans chaque alternance passe par la valeur zéro jusqu'à l'instant où le courant de boucle atteint une valeur correspondant au courant de saturation des transformateurs d'isolement. L'inconvénient avec ce dispositif connu est que les limites de la fenêtre d'intégration ne peuvent être déterminées de manière précise à l'avance en raison des variations de construction et de fonctionnement d'un transformateur à l'autre. Dans la pratique, un appareil sophistiqué, par exemple un oscilloscope, est nécessaire pour régler séparément chaque dispositif sur place afin d'ajuster le début et la fin de la fenêtre d'intégration lorsque le courant de boucle passe par zéro et atteint la valeur de saturation respectivement. De plus, les limites de la fenêtre d'intégration ne peuvent être aisément reconnues, en particulier lorsque la boucle est alimentée par un régulateur de courant du type à résonance.

Cette imprécision dans la détermination de la largeur de la fenêtre d'intégration est préjudiciable à la précision de la détection puisque, pour obtenir une bonne précision de détection, il y a intérêt à déterminer l'intégrale de tension sur un intervalle de temps durant lequel les crêtes de tension superposées ont une valeur significative. En outre, l'imprécision dans la détermination de la largeur de la fenêtre d'intégration est d'autant plus préjudiciable à la précision de détection que le pourcentage de balises défectueuses est faible et notamment lorsque la boucle est alimentée par un régulateur de courant à résonance qui délivre un courant de sortie quasi-sinusoïdal.

Pour éviter les inconvénients précités de l'art antérieur, la présente invention propose un procédé pour détecter le nombre de balises défectueuses dans une installation de balises d'aérodromes, et également un dispositif de surveillance de balises lumineuses qui met en oeuvre le procédé de détection selon l'invention.

L'invention a donc pour objet un procédé pour détecteur le nombre de balises défectueuses dans un ensemble de balises connectées dans une boucle tel que défini dans le préambule de la revendication 1, et qui se caractérise par la génération d'un signal de tension témoin répondant à la variation de l'induction produite dans un transformateur de courant ayant un circuit primaire connecté dans la boucle de manière à saturer le noyau magnétique de ce transformateur et un circuit secondaire ouvert, par la génération d'un signal fenêtre de validation uniquement pendant un intervalle de temps durant lequel le signal de tension témoin a une valeur significative, par la génération d'un signal représentant l'intégrale de la tension de la boucle pendant la durée du signal fenêtre de validation, et par la génération d'un signal de détection en réponse au signal représentant l'intégrale de la tension de boucle et à un signal représentant la tension de la boucle lorsque toutes les balises sont opérationnelles, ledit signal de détection étant proportionnel à la différence entre les signaux précités, ce signal de détection indiquant le nombre de balises défectueuses.

Suivant un second aspect, l'invention a pour objet un dispositif de surveillance de balises lumineuses tel que défini dans le préambule de la revendication 2, et que se caractérise par un transformateur de courant témoin saturé ayant un enroulement primaire connecté en série avec la boucle et un enroulement secondaire en circuit ouvert, ledit transformateur de courant témoin étant le siège, à son enroulement secondaire, d'un signal de tension à chaque inversion d'alternance du courant primaire; un circuit de validation connecté pour recevoir le signal de tension témoin, ce circuit étant agencé pour produire à sa sortie un signal fenêtre de validation uniquement pendant l'intervalle de temps durant lequel le signal de tension témoin a une valeur significative; un circuit intégrateur connecté pour répondre à un signal de tension image de la tension de la boucle et au signal fenêtre de validation afin de produire un signal de sortie proportionnel à l'intégrale dudit signal de tension pendant la durée du signal fenêtre de validation; et un soustracteur pour soustraire dudit signal de sortie ou signal intégré, un signal représentant la tension de la boucle lorsque toutes les balises sont opérationnelles de manière à produire un signal de détection représentant le nombre de balises défectueuses.

Le procédé et le dispositif selon l'invention ont pour avantage d'assurer une précision de détection élevée dans nécessiter un réglage sur place du début et de la fin de la fenêtre d'intégration, même dans les cas où le pourcentage de balises défectueuses à détecter est faible et même lorsque les balises sont connectées en série dans une boucle alimentée par un régulateur de courant à résonance.

L'invention est exposée dans ce qui suit à l'aide d'un mode de réalisation exemplaire illustré par les dessins ci-annexés dans lesquels:

la figure 1 est un schéma général d'une boucle de balises lumineuses typique à laquelle est associé un dispositif de surveillance selon l'invention,

les figures 2 à 5 sont des diagrammes de formes d'ondes illustrant le procédé mis en oeuvre dans le dispositif selon l'invention.

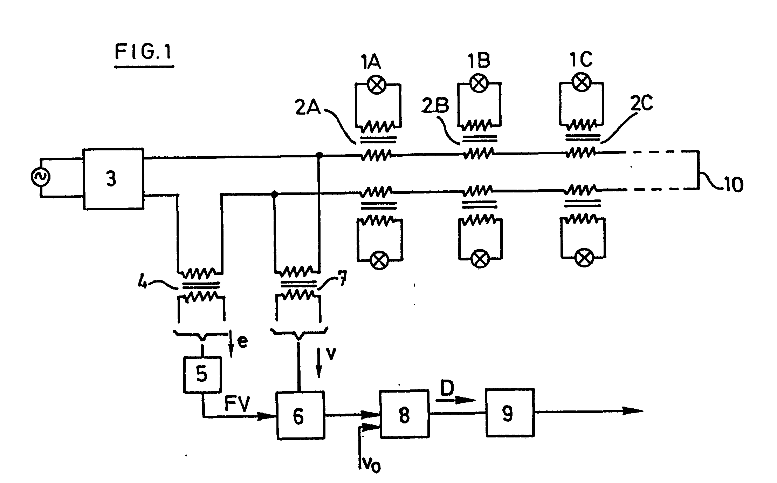

La schéma de la figure 1 représente une installation de balises d'aérodrome typique. Plusieur balises 1A, 1B, 1C . . ., dont le nombre peut être quelconque, sont couplées à une boucle 10 par des transformateurs d'isolement 2A, 2B, 2C . . ., identiques en principe, alimentés en série par l'intermédiaire d'un régulateur à courant constant 3 débitant un courant alternatif. Les circuits primaires des transformateurs d'isolement 2A, 2B . . . sont connectés en série.

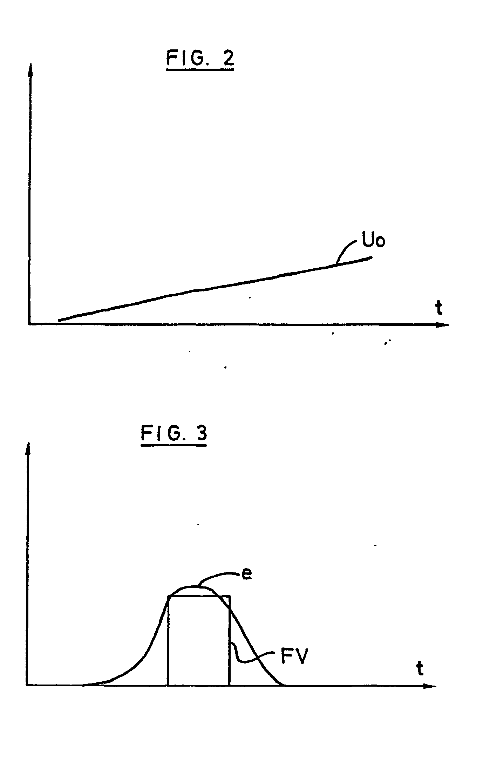

Selon l'invention, un transformateur de courant témoin 4 est connecté en série avec le régulateur 3. Ce transformateur témoin est un transformateur à noyau saturé par le courant de boucle et il a un circuit secondaire ouvert. Le transformateur témoin 4 est le siège d'un signal de tension $e$ de courte durée aux environs de chaque inversion d'alternance du courant primaire. Ce signal de tension $e$, que l'on appellera signal de tension témoin, est représenté dans le diagramme de la figure 3. Dans ce diagramme, ainsi que dans ceux des figures 2, 4 et 5, l'axe des abscisses porte l'échelle des temps élargie. Le diagramme de la figure 2 représente un tronçon de la forme d'onde de la tension de boucle Uo lorsque toutes les balises sont opérationnelles.

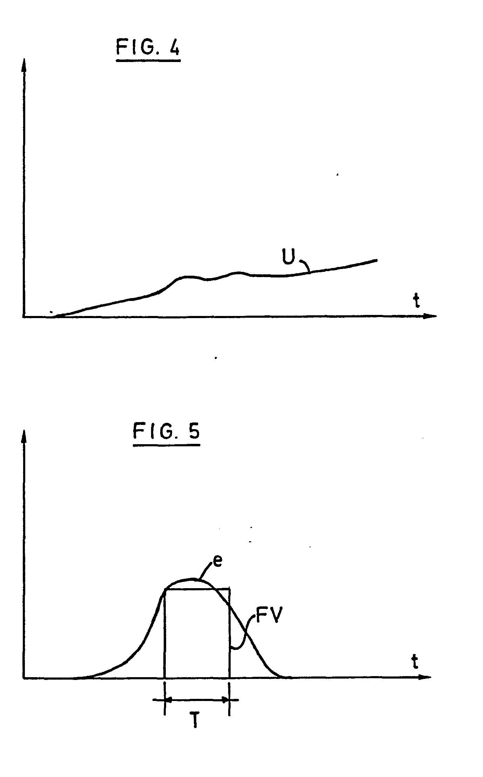

Lorsqu'une balise 1n est défectueuse, une pointe de tension apparaît sur le transformateur d'isolement 2n correspondant et elle se superpose à la tension Uo de la boucle 10, comme expliqué plus haut. La figure 4 montre à titre d'exemple, un tronçon du profil de la tension de boucle U résultant de l'ouverture du circuit secondaire d'un petit nombre de transformateurs d'isolement: on observe la perturbation superposée à la tension; de base. La figure 5 montre le profil du signal de tension témoin $e$ correspondant sur le transformateur 4.

Pour détecter la perturbation qui apparaît dans le profil de la tension de boucle et qui est une image du nombre de balises défectueuses, l'invention utilise la partie significative du signal de tension témoin $e$. Le signal de tension témoin $e$ est appliqué à un circuit de validation 5 (figure 1) agencé pour produire un signal uniquement pendant l'intervalle de temps durant lequel le signal de tension témoin a une valeur significative. Dans un exemple de réalisation, le circuit de validation 5 est agencé pour intégrer le signal de tension témoin $e$ et engendrer un signal de sortie lorsque cette intégrale est comprise entre une première fraction de la surface sous la courbe du signal témoin $e$ (par exemple 20%) et une seconde fraction de cette surface (par exemple 80%).

Dans un autre mode de réalisation, le circuit de validation pourrait être agencé pour engendrer un signal de sortie lorsque l'amplitude du signal de tension témoin $e$ est comprise entre deux valeurs de seuil prédéterminées.

Le signal de sortie du circuit de validation est appelé fenêtre de validation FV. Ce signal est utilisé pour commander un intégrateur 6 recevant un signal de tension $v$ engendré par un transformateur de tension 7 connecté pour engendrer un signal image de la tension U de la boucle 10. L'intégrateur 6 est agencé pour intégrer le signal de tension $v$ pendant la durée de la fenêtre de validation FV, la largeur et la position de la fenêtre de validation étant déterminées de manière précise par le dispositif de surveillance lui-même.

La figure 5 représente un signal fenêtre de validation FV produit lorsque l'intégrale, en fonction du temps, du signal de tension $e$ est comprise entre 20% et 80% de la surface sous la courbe $e$, de manière que la perturbation de la tension U (figure 4) soit prise en considération pendant l'intervalle de temps T, c'est-à-dire pendant la durée du signal fenêtre de validation FV. Il est à remarquer que le temps d'intégration T est déterminé, selon l'invention, par référence au signal de tension témoin $e$ et cette détermination se fait avec grande précision, quelle que soit la forme d'onde du courant et quel que soit le nombre de balises défectueuses.

Le signal de sortie de l'intégrateur 6 est appliqué à une entrée d'un soustracteur 8 qui reçoit à une seconde entrée un signal Vo représentant la tension Uo de la boucle lorsque toutes les balises sont opérationnelles. A la sortie du circuit 8 on obtient alors un signal de détection D qui est une image de la perturbation correspondant à la balise ou aux balises défectueuses, et qui est donc indicatif du nombre de balises défectueuses. Le signal de détection D peut être appliqué à un dispositif d'alarme quelconque 9, analogique ou numérique, organisé pour indiquer le nombre de balises défectueuses et produire un signal d'alarme approprié.

Le signal de détection D peut être appliqué à un dispositif d'indication et/ou d'alarme de manière à produire un signal indiquant le nombre de balises défectueuses et/ou un plusieurs signaux d'alarme lorsque le nombre de balises défectueuses atteint une valeur prédéterminée. Il est entendu que le dispositif d'alarme peut être prévu également pour produire au moins un signal de pré-alarme lorsque le nombre de balises défectueuses atteint une valeur prédéterminée inférieure à la valeur produisant un signal d'alarme.

## Revendications

1. Procédé pour détecter le nombre de balises lumineuses défectueuses dans un ensemble de balises (1A, 1B, 1C, . . .) alimentées chacune par un transformateur d'isolement (2A, 2B, 2C, . . .) les transformateurs d'isolement ayant leurs circuits primaires connectés en série avec une source (3) de courant alternatif, formant ainsi une boucle (10), le courant parcourant le primaire de chaque transformateur étant, lorsque les balises sont operationnelles, beaucoup plus grand que le courant de saturation de chaque transformateur respectif, comprenant les phases suivantes: génération d'un signal représentant l'intégrale de la tension de la boucle (10) sur un certain intervalle de temps d'intégration et génération d'un signal de détection (D) proportionnel à la différence entre le signal représentant cette intégrale de la tension de boucle (10) et un signal (Vo) représentant la tension de la boucle (10) lorsque toutes les balises (1A, 1B, 1C . . .) sont opérationnelles, ledit signal de détection (D) indiquant le nombre de balises défectueuses, caractérisé par les phases suivantes: génération d'un signal de tension témoin (e) répondant à la variation de l'induction produite dans un transformateur de courant (4) ayant un circuit primaire connecté dans la boucle (10) de manière à saturer le noyau magnétique de ce transformateur (4), et un circuit secondaire ouvert; génération d'un signal de fenêtre de validation (FV) uniquement pendant un intervalle de temps (T) durant lequel le signal de tension témoin (e) a une valeur significative; et génération du signal représentant l'intégrale de la tension de la boucle (10) en prenant la durée du signal de fenêtre de validation (FV) pour l'intervalle de temps d'intégration.

2. Dispositif de surveillance de balises lumineuses (1A, 1B, 1C, . . .) alimentés chacune par un transformateur l'isolement (2A, 2B, 2C, . . .), les transformateurs d'isolement ayant leurs circuits primaires connectés en série avec une source (3) de courant alternatif, formant une boucle (10) dans laquelle le courant parcourant le primaire de chaque transformateur est, lorsque les balises sont operationnelles, beaucoup plus grand que le courant de saturation de chaque transformateur respectif, caractérisé par un transformateur de courant témoin saturable (4) ayant un enroulement primaire connecté en série avec la boucle et un enroulement secondaire en circuit ouvert, ledit transformateur de courant témoin étant le siège à son secondaire, d'un signal de tension témoin (e) à chaque inversion d'alternance du courant primaire; un circuit de validation (5) connecté pour recevoir le signal de tension témoin (e), ce circuit étant agencé pour produire à sa sortie un signal fenêtre de validation (FV) uniquement pendant l'intervalle de temps (T) durant lequel le signal de tension témoin (e) a une valeur significative; un circuit intégrateur (6) connecté pour répondre à un signal de tension (v) image de la tension de la boucle (U) et au signal fenêtre de validation (FV) afin de produire un signal de sortie proportionnel à l'intégrale dudit signal de tension (v) image de la tension de la boucle pendant la durée du signal de fenêtre de validation (FV); et un soustracteur (8) pour soustraire dudit signal de sortie, un signal (Vo) représentant la tension de la boucle lorsque toutes les balises sont opérationnelles afin de produire un signal de détection (D) représentant le nombre de balises défectueuses.

3. Dispositif selon la revendication 2, caractérisé en ce que le circuit de validation (5) est agencé pour intégrer pendant chaque période du courant alternatif le signal de tension témoin (e) en fonction du temps et engendrer un signal de sortie lorsque l'intégrale de ce signal est comprise entre une première fraction de la surface sous la courbe du signal de tension témoin (e) en fonction du temps et une seconde fraction de ladite surface.

4. Dispositif selon la revendication 2, caractérisé en ce que le circuit de validation (5) est agencé pour engendrer le signal fenêtre de validation (FV) lorsque l'amplitude du signal de tension témoin (e) est comprise entre une première valeur de seuil prédéterminée et une seconde valeur de seuil prédéterminée.

5. Dispositif selon l'une quelconque des revendications 2 à 4, caractérisé en ce qu'il comprend un dispositif d'alarme (9) répondant au signal de détection (D) afin de produire au moins un signal indiquant le nombre de balises défectueuses et/ou un signal d'alarme lorsque le nombre de balises défectueuses atteint une valeur prédéterminée.

6. Dispositif selon la revendication 5, caractérisé en ce qu'il comprend un dispositif de pré-alarme répondant au signal de détection (D) afin de produire au moins un signal de pré-alarme lorsque le nombre de balises défectueuses atteint une valeur prédéterminée inférieure à la valeur correspondant à un signal d'alarme.

## Patentansprüche

1. Verfahren zum Erfassen der Zahl ausgefallener Markierungslichter in einer Gruppe von Markierungen (1A, 1B, 1C, ...), die jeweils mittels eines Trenntransformators (2A, 2B, 2C, ...) gespeist werden, wobei die Primärkreise der Trenntransformatoren in Reihe mit einer Wechselstromquelle (3) geschaltet sind und somit eine Schleife (10) bilden, ferner der die Primärseite jedes Transformators bei Funktionieren der Markierungen durchfließende Strom viel größer als der Sättigungsstrom jedes jeweiligen Transformators ist, mit folgenden Schritten:

Erzeugen eines Signals, welches das Integral der Spannung der Schleife (10) über einem bestimmten Integrations-Zeit-intervall repräsentiert, und Erzeugen eines Erfassungssignals (D), welches proportional ist zur Differenz zwischen dem dieses Integral der Schleifenspannung repräsentierenden Signal und einem die Schleifenspannung bei Funktionieren aller Markierungen (1A, 1B, 1C, ...) repräsentierenden Signal (Vo), wobei das Erfassungssignal (D) die Zahl ausgefallener Markierungen angibt, gekennzeichnet durch folgende Schritte:

Erzeugen eines Kontroll-Spannungssignals (e), das auf die Änderung der in einem Stromtransformator (4) hervorgerufenen Induktion anspricht, welcher Stromtransformator (4) einen Primärkreis, der in einer den Magnetkern dieses Transformators (4) sättigenden Weise in die Schleife (10) geschaltet ist, und einen offenen Sekundärkreis aufweist; Erzeugen eines Freigabefenster-Signals (FV) ausschließlich während eines Zeitintervalls (T), während dessen das Kontroll-Spannungssignal (e) einen aussagekräftigen Wert besitzt; und

Erzeugen des das Integral der Schleifenspannung repräsentierenden Signals durch Verwenden der Dauer des Freigabefenster-Signals (FV) als das Integrations-Zeitintervall.

2. Vorrichtung zur Überwachung von Markierungslichtern (1A, 1B, 1C, ...), die jeweils mittels eines Trenntransformators (2A, 2B, 2C, ...) gespeist sind, wobei die Primärkreise der Trenntransformatoren in Reihe mit einer Wechselstromquelle (3) geschaltet sind und eine Schleife (10) bilden, in welcher der die Primärseite jedes Transformators bei Funktionieren der Markierungen durchfliessende Strom viel größer als der Sättigungsstrom jedes jeweiligen Transformators ist, gekennzeichnet durch einen sättigbaren Kontroll-Stromtransformator (4) mit einer zu der Schleife in Reihe geschalteten Primärwicklung und einer leerlaufenden Sekundärwicklung, der an seiner Sekundärwicklung Ausgangspunkt eines Spannungssignals (e) bei jeder Richtungsumkehr des Primärstroms ist; einen Freigabe-Schaltkreis (5) mit einer Verbindung für den Empfang des Kontroll-Spannungssignals (e), der eingerichtet ist, an seinem Ausgang ein Freigabefenster-Signal (FV) ausschließlich während des Zeitintervalls (T) zu erzeugen, während dessen das Kontroll-Spannungssignal (e) einen aussagekräftigen Wert besitzt; einen Integrator-Schaltkreis (6), der so geschaltet ist, daß er auf ein der Schleifenspannung (U) entsprechendes Spannungssignal (v) und auf das Freigabefenster-Signal (FV) anspricht, um ein Ausgangssignal zu erzeugen, das zum Integral des der Schleifenspannung entsprechenden Spannungssignals (v) während der Dauer des Freigabefenster-Signals (FV) proportional ist; und einen Subtrahierer (8) zum Subtrahieren eines die Schleifenspannung bei Funktionieren aller Markierungen repräsentierenden Signals (Vo) von dem genannten Ausgangssignal, um ein die Zahl ausgefallener Markierungen repräsentierendes Erfassungssignal (D) zu erzeugen.

3. Vorrichtung nach Anspruch 2, dadurch gekennzeichnet, daß der Freigabe-Schaltkreis (5) ausgebildet ist, während jeder Periode des Wechselstroms das Kontroll-Spannungssignal (e) als Funktion der Zeit zu integrieren und ein Ausgangssignal zu erzeugen, wenn das Integral dieses Signals zwischen einem ersten Bruchteil der Fläche unter der Kurve des Kontroll-Spannungssignals (e) und einem zweiten Bruchteil der genannten Fläche liegt.

4. Vorrichtung nach Anspruch 2, dadurch gekennzeichnet, daß der Freigabe-Schaltkreis (5) ausgebildet ist, das Freigabefenster-Signal (FV) zu erzeugen, wenn die Amplitude des Kontroll-Spannungssignals (e) zwischen einem ersten vorbestimmten Schwellenwert und einem zweiten vorbestimmten Schwellenwert liegt.

5. Vorrichtung nach einem der Ansprüche 2 bis 4, dadurch gekennzeichnet, daß sie eine Warneinrichtung (9) umfaßt, die auf das Erfassungssignal (D) anspricht, um wenigstens ein die Zahl ausgefallener Markierungen angebendes Signal und/oder ein Warnsignal zu erzeugen, wenn die Zahl ausgefallener Markierungen einen vorbestimmten Wert erreicht.

6. Vorrichtung nach Anspruch 5, dadurch gekennzeichnet, daß sie eine Vorwarn-Einrichtung umfaßt, die auf das Erfassungssignal (D) anspricht, um wenigstens ein Vorwarn-Signal zu erzeugen, wenn die Zahl ausgefallener Markierungen einen vorbestimmten Wert erreicht, der unter dem einem Warnsignal entsprechenden Wert liegt.

## Claims

1. Method for detecting the number of defective marker lights in a set of markers (1A, 1B, 1C, ...), each of these markers being fed by an isolation transformer (2A, 2B, 2C, ...), the isolation transformers having their primary circuits connected in series to an alternating current power supply (3), thus forming a loop circuit (10), the current flowing through the primary of each transformer being, when the markers are operating, much greater than the saturation current of each representative transformer, the method comprising the following steps:

generation of a signal representing the integral of the voltage of the loop circuit (10) over a certain integration time interval, and generation of a detection signal (D) proportional to the difference between the signal representing this integral of the loop circuit (10) voltage and a signal (Vo) representing the voltage of the loop circuit (10) when all the markers (1A, 1B, 1C, . . .) are in operation, the said detection signal (D) indicating the number of defective markers, characterised by the following steps:

generation of a voltage monitoring signal (e) responding to the variation in the induction produced in a current transformer (4) having a primary circuit connected into the loop circuit (10) so that the magnetic core of this transformer (4) is saturated, and an open secondary circuit;

generation of an enabling window signal (FV) solely for a time interval (T) during which the voltage monitoring signal (e) has a significant value; and

generation of the signal representing the integral of the voltage of the loop circuit (10), taking as the integration time interval the duration of the enabling window signal (FV).

2. Marker light monitoring device, each marker light (1A, 1B, 1C, . . .) being fed by an isolation transformer (2A, 2B, 2C, . . .), the isolation transformers having their primary circuits connected in series to an alternating current power supply (3), forming a loop circuit (10) in which the current flowing through the primary of each transformer is, when the markers are in operation, much greater than the saturation current of each respective transformer, characterised by a saturable monitoring current transformer (4) having a primary winding connected in series to the loop circuit and a secondary winding in open circuit, the said monitoring current transformer receiving, at its secondary winding, a voltage monitoring signal (e) at each reversal of the alternating primary current; an enabling circuit (5) connected to receive the voltage monitoring signal (e), this circuit being arranged to produce at its output an enabling window signal (FV) solely for the time interval (T) during which the voltage monitoring signal (e) has a significant value; an integrating circuit (6) connected to act upon a voltage signal (v), which is a representation of the voltage of the loop circuit (U), and upon the enabling window signal (FV), in order to produce an output signal proportional to the integral of the said voltage signal (v), which voltage signal is a representation of the voltage of the loop circuit, over the duration of the enabling window signal (FV); and a subtracter (8) for subtracting from the said output signal a signal (Vo), representing the voltage of the loop circuit when all the markers are in operation, in order to produce a detection signal (D) representing the number of defective markers.

3. Device according to claim 2, characterised in that the enabling circuit (5) is arranged to integrate, during each period of the alternating current, the voltage monitoring signal (e) over time, and to generate an output signal when the integral of this signal is between a first fraction of the area below the curve of the voltage monitoring signal (e) in dependence upon time, and a second fraction of the said area.

4. Device according to claim 2, characterised in that the enabling circuit (5) is arranged for generating the enabling window signal (FV) when the amplitude of the voltage monitoring signal (e) is between a first predetermined threshold value and a second predetermined threshold value.

5. Device according to any one of claims 2 to 4, characterised in that it comprises an alarm device (9) responding to the detection signal (D) in order to produce at least one signal indicating the number of defective markers and/or an alarm signal when the number of defective markers reaches a predetermined value.

6. Device according to claim 5, characterised in that it comprises a prealarm device responding to the detection signal (D) in order to produce at least one prealarm signal when the number of defective markers reaches a predetermined value which is lower than the value corresponding to an alarm signal.

FIG.1

## FIG. 2

## FIG. 3

FIG. 4

FIG. 5